# EUROPÄISCHE PATENTSCHRIFT

(11) **EP 0 463 481 B1**
(45) Veröffentlichungstag und Bekanntmachung des Hinweises auf die Patenterteilung: **23.08.1995**
(21) Anmeldenummer: 91109658.4
(22) Anmeldetag: 12.06.1991
(51) Int. Cl.: G01R 33/035

(54) **Einrichtung zur Kühlung einer SQUID-Messvorrichtung**
Cooling arrangement for a squid measurement device
Dispositif de refroidissement pour un dispositif de mesure à squid

(30) Priorität: 25.06.1990 EP 90112052; 07.12.1990 DE 4039129
(43) Veröffentlichungstag der Anmeldung: 02.01.1992
(73) Patentinhaber: SIEMENS AKTIENGESELLSCHAFT, 80333 München (DE)
(72) Erfinder: Schnapper, Christoph, Dr., W-8520 Erlangen (DE)

(56) Entgegenhaltungen:
- EP-A- 0 361 137
- FR-A- 2 622 977
- PATENT ABSTRACTS OF JAPAN, Band 13, Nr. 586 (P-982) 25. Dezember 1989;& JP-A-63077 378 (SHIMADZU CORP.) 05-10-1989
- PROCEEDINGS OF THE 5TH CRYOCOOLER CONFERENCE, Monterey, CA, 1988, Seiten 35-46;D.S. BUCHANAN et al.: "Development of a hybrid Gifford-McMahon JouleThompson based neuromagnetomer cryosquid"
- PATENT ABSTRACTS OF JAPAN, Band 6, Nr. 140 (E-121)[1018], 29. Juli 1982;& JP-A-57 64 906 (TOKYO SHIBAURA) 20-04-1982
- PATENT ABSTRACTS OF JAPAN, Band 13, Nr. 580 (P-980), 21. Dezember 1989;& JP-A-63 072 137 (HITACHI) 29-09-1989

## Beschreibung

Die Erfindung bezieht sich auf eine Einrichtung zur Kühlung einer SQUID-Meßvorrichtung gemäß der Veröffentlichung "CRYOSQUID-Proc. of the 5th Cryocooler Conf. (Cryocoolers 5)", Monterey, CA (US), 1988, Seiten 35 bis 46.

Zur Messung sehr schwacher Magnetfelder ist eine Verwendung von supraleitenden Quanten-Interferometern, sogenannten "SQUIDs" (Abkürzung von: "Superconducting QUantum Interference Devices"), allgemein bekannt (vgl. z.B. "J. Phys.E.: Sci. Instrum.", Vol. 13, 1980, Seiten 801 bis 813 oder "IEEE Trans. Electron Dev.", Vol. ED-27, No. 10, Oktober 1980, Seiten 1896 bis 1908). Als ein bevorzugtes Anwendungsgebiet für diese Interferometer wird auf dem Gebiet der medizinischen Diagnostik die Magnetokardiographie oder Magnetoenzephalographie angesehen. Die hierbei hervorgerufenen Magnetfelder von magnetischen Herz- bzw. Gehirnströmen haben nämlich Feldstärken in der Größenordnung von nur etwa 50 pT bzw. 0,1 pT (vgl. z.B. "Biomagnetism - Proceedings Third International Workshop on Biomagnetism, Berlin 1980", Berlin/New York 1981, Seiten 3 bis 31). Diese sehr schwachen Felder oder deren Feldgradienten müssen zudem noch bei Anwesenheit von verhältnismäßig großen Störfeldern zu detektieren sein. Zur Messung derartiger biomagnetischer Felder in der genannten Größenordnung sind Meßvorrichtungen bekannt, die ein- oder insbesondere auch mehrkanalig ausgeführt sein können (vgl. z.B. EP-B-0 111 827). Diese Meßvorrichtungen enthalten eine der Anzahl ihrer Kanäle entsprechende Zahl von SQUIDs und Magnetometer oder Gradiometer zum Empfang der zu detektierenden Feldsignale. Dabei weisen die Magnetometer im Gegensatz zu Gradiometern jeweils nur eine einzige Detektionsschleife auf und können deshalb auch als Gradiometer nullter Ordnung angesehen werden. Bei der nachfolgend benutzten Bezeichnung "Gradiometer" soll deshalb generell auch eine Verwendung von Magnetometern statt Gradiometern mit eingeschlossen sein.

Bei den bekannten SQUID-Meßvorrichtungen, die auch als SQUID-Magnetometer bezeichnet werden, sind jedoch die die supraleitenden Gradiometer und SQUIDs aufnehmenden Kryostaten im allgemeinen oberhalb der zu detektierenden Feldquelle eines zu untersuchenden Patienten angeordnet. Geht man von Füllmengen von etwa 15 bis 30 Litern pro Kryostat an flüssigem Kältemittel wie flüssigem Helium (LHe) aus, wie sie z.B. für mehrkanalige Meßvorrichtungen bei hinreichend großen Nachfüllintervallen üblich sind, so führt die gewählte Anordnung der Kryostaten zu einer eventuellen Gefährdung des direkt darunterliegenden Patienten. Im Fall eines plötzlichen Zusammenbruchs des Isoliervakuums bzw. einer plötzlichen Beschädigung des Kryostaten mit Ansprechen von Sicherheitsventilen würde sich nämlich eine nicht unbedenkliche Kaltgasmenge über den Patienten ergießen. So erzeugen z.B. die erheblichen Helium-Füllmengen von 15 bis 30 Litern Flüssigkeit in einem entsprechenden Notfall etwa 10 bis 30 m³ Helium-Kaltgas. Dieses Kaltgas ist schwerlich vom Patienten fernzuhalten, insbesondere dann, wenn die Untersuchung in einer Abschirmkabine durchgeführt wird. Eine Überkopf-Anordnung von Kryostaten mit verhältnismäßig großer Ausdehnung kann außerdem von Patienten als unangenehm empfunden werden.

Auch bei der aus der US-A-4′827′217 zu entnehmenden Kühleinrichtung einer SQUID-Meßvorrichtung sind erhebliche Mengen eines Kältemittels in einem Kryostaten oberhalb eines Patienten vorhanden. Das Kältemittel befindet sich dabei in einem eigenen Vorratsbehälter innerhalb des Kryostaten. Ein SQUID und die zugeordneten supraleitenden Spulen eines Gradiometers sind in einem Vakuumraum unterhalb dieses Vorratsbehälters innerhalb des Kryostaten angeordnet und über Teile aus gut-wärmeleitendem Material an diesen Vorratsbehälter und damit an das in ihm befindliche Kältemittel thermisch angekoppelt. Der Kryostat dieser bekannten Kühleinrichtung mit indirekter Kühlung der supraleitenden Teile der SQUID-Meßvorrichtung erfordert jedoch einen sehr aufwendigen Aufbau und wegen eines zu fordernden Kältemittelvorrates entsprechend große Abmessungen.

Eine indirekte Kühlung für eine SQUID-Meßvorrichtung ist auch in der W0-A-85/04489 offenbart. Bei dieser bekannten Vorrichtung ist eine seitliche Anordnung des Kryostaten von der zu detektierenden Feldquelle möglich.

Auch aus der eingangs genannten Veröffentlichung "Cryo-coolers 5" ist eine Kühleinrichtung einer SQUID-Meßvorrichtung zu entnehmen, deren Kryostat seitlich oder unterhalb eines Patienten angeordnet werden kann. Dabei ist zur Kühlung der supraleitenden Teile eine Kombination aus LHe-Bad und vielen He-Gas-Strömen vorgesehen. Die SQUIDs werden mittels eines Einsatzes gekühlt, der mit LHe gefüllt ist, während die Gradiometer abgasgekühlt sind. Nachfüllintervall ist etwa 1 Tag. Zwar sind bei dieser bekannten Kühleinrichtung wegen der vorbestimmten Lage des Kryostaten die erwähnten Sicherheitsprobleme klein; und es wird nur ein verhältnismäßig geringer LHe-Vorrat benötigt. Jedoch ist das Nachfüllintervall verhältnismäßig kurz. Für das Nachfüllen ist zumindest einmal pro Tag ein LHe-Transportbehälter in eine Abschirmkammer einzubringen, in der sich die SQUID-Meßvorrichtung befindet. Außerdem ist die Aufteilung des Gasstromes in mehrere parallelgeschaltete Ströme für die verschiedenen Gradiometer sehr problematisch. Darüber hinaus ist eine Temperaturregelung nicht vorgesehen und auch kaum möglich. Auch die Einstellung einer LHe-Verdampfungsrate ist ohne zusätzliche Maßnahmen nicht durchführbar. Wie bei einer LHe-Badkühlung wird auch hier ein kalter, helium- und vakuum-dichter Behälter des Kryostaten benötigt.

Bei den bekannten SQUID-Meßvorrichtungen wird bisher im allgemeinen auf eine Kühlung ihrer supraleitenden Teile, insbesondere der SQUIDs, unter Einsatz von Kältemaschinen (Refrigeratoren) verzichtet. Diese Maschinen können nämlich mit ihrer elektromagnetischen Abstrahlung und mit ihren bewegten magnetischen Teilen über Vibrationen magnetische Störfelder erzeugen, die von der SQUID-Meßvorrichtung direkt oder indirekt datektiert werden und deshalb unbedingt vermieden werden müssen. Kleine Kältemaschinen mit hinreichender Kälteleistung und einer Betriebstemperatur unter 6 K sind an sich bekannt. Sie arbeiten entweder nach dem sogenannten Linde-Claude-Prinzip (vgl. z.B. "Linde-Berichte aus Technik und Wissenschaft", Nr. 64: "Der Linde-Refrigerator für die Kernspintomographie", 1990, Seiten 38 bis 45). Auch kann eine Kombination eines zweistufigen Gifford-McMahon-(GM)-Refrigerators für einen Temperaturbereich oberhalb von 10 K mit zusätzlichem Joule-Thomson(JT)-Kreislauf vorgesehen sein (vgl. die genannte Textstelle aus "Cryocoolers 5").

Bekannt geworden sind auch Refrigeratoren, die nach dem GM-Prinzip eine Temperatur von etwa 4 K erreichen. Als Regeneratoren werden hierfür spezielle magnetische Materialien wie z.B. GdₓEr₁₋ₓRh eingesetzt, die wegen eines magnetischen Phasenüberganges auch unterhalb von 10 K eine erhebliche spezifische Wärme aufweisen (vgl. z.B. "Adv. Cryog. Engng.", Vol. 35 b, 1990, Seiten 1251 bis 1260). Neben einer in der genannten nannten Textstelle aus "Cryocoolers 5" aufgezeigten direkten Kopplung einer Kältemaschine und einer SQUID-Meßvorrichtung sind auch andere Maßnahmen zur thermischen Kopplung von tiefkalten Geräten und Kältemaschinen insbesondere aus dem Bereich supraleitender Magnete bekannt (vgl. z.B. "Cryogenics", Vol. 24, 1984, Seiten 175 bis 178).

Aufgabe der vorliegenden Erfindung ist es nun, die Kühleinrichtung mit den eingangs genannten Merkmalen dahingehend auszugestalten, daß die Anordnung eines Kryostaten zu keiner Beeinträchtigung der zu detektierenden Feldquelle, insbesondere zu keiner Gefährdung eines Patienten führen kann. Dabei soll sich nur eine verhältnismäßig geringe Kältemittelmenge im Bereich der Feldquelle befinden, so daß der Kryostat entsprechend kleine Abmessungen haben kann.

Diese Aufgabe wird erfindungsgemäß mit den in Anspruch 1 angegebenen Maßnahmen gelöst.

Die sich bei dieser erfindungsgemäßen Ausgestaltung der Kühleinrichtung ergebenden Vorteile sind insbesondere darin zu sehen, daß ein besonderer Kältemittelvorrat in dem das Meßsystem aufnehmenden Kryostaten nicht erforderlich ist und deshalb der Kryostat verhältnismäßig klein gestaltet werden kann. Außerdem kann der Kryostat nahezu beliebig im Raum ausgerichtet werden. Da im Meßsystem und innerhalb einer eventuell vorhandenen Abschirmkabine nur sehr wenig Kältemittel vorhanden ist, treten praktisch keine Sicherheitsprobleme auf. Das Kältemittel strömt dabei nur innerhalb der Kühlkanäle, die helium- und vakuumdicht ausgebildet sein müssen. Wegen des Wegfalls eines besonderen Heliumbehälters innerhalb des Kryostaten, der bei bekannten Konzepten zu einer Vergrößerung des Abstandes der Gradiometer von der jeweils zu detektierenden Feldquelle führt, können bei der erfindungsgemäßen Kühleinrichtung die Gradiometer vorteilhaft verhältnismäßig nah an der Feldquelle plaziert werden. Die Meßempfindlichkeit ist dementsprechend hoch.

Vorteilhafte Ausgestaltungen der erfindungsgemäßen Kühleinrichtung gehen aus den abhängigen Ansprüchen hervor.

Zur weiteren Erläuterung der Erfindung wird nachfolgend auf die schematische Zeichnung Bezug genommen, in deren

Figur 1 eine Kühleinrichtung nach der Erfindung mit einem Kältemittelbehälter veranschaulicht ist.

In den Figuren 2 und 3 sind Möglichkeiten zu einer Regelung des Kältemittelstromes in den Kältemittelleitungen dieser Kühleinrichtung angedeutet.

Die Figuren 4 und 5 zeigen die Ausbildung eines Teils der Kühlkanäle dieser Kühleinrichtung.

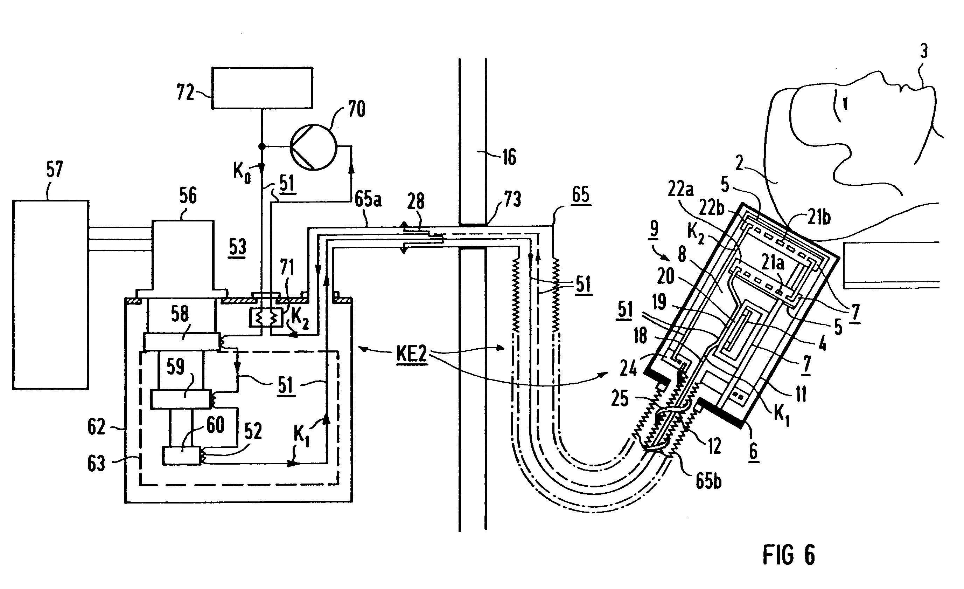

Aus Figur 6 ist eine erfindungsgemäße Kühleinrichtung mit einer Kältemaschine zu entnehmen.

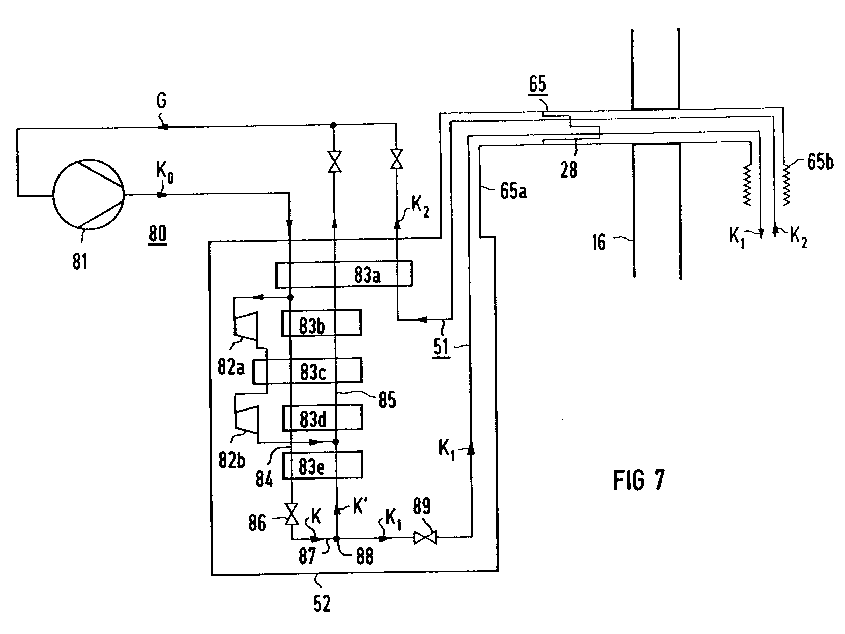

Figur 7 zeigt eine weitere, für eine Kühleinrichtung nach der Erfindung geeignete Kältemaschine.

In den Figuren sind sich entsprechende Teile mit denselben Bezugszeichen versehen.

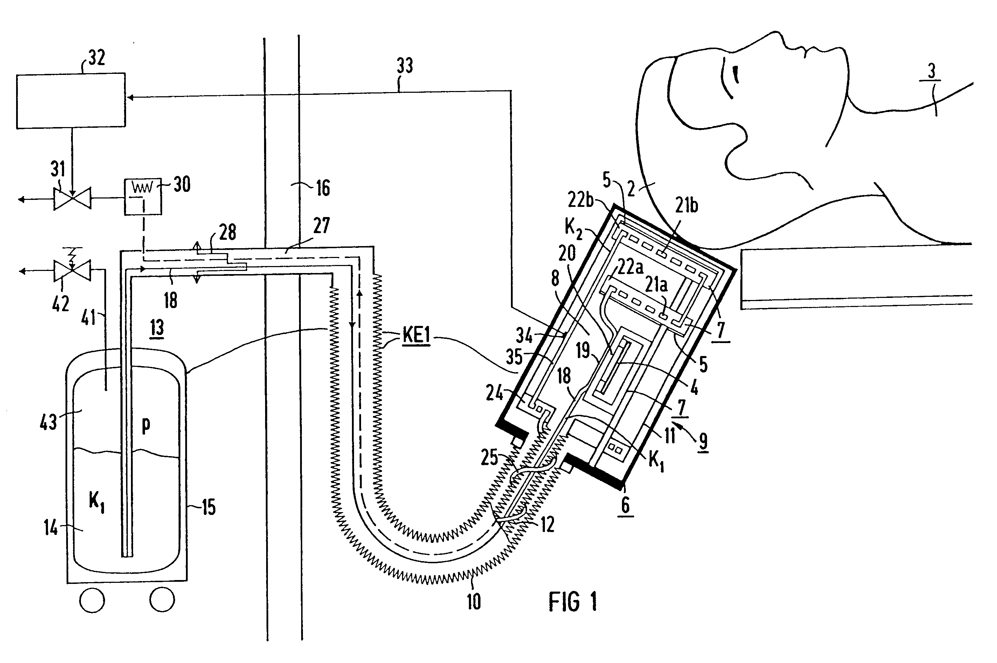

SQUID-Meßvorrichtungen, mit denen sich äußerst schwach magnetische Signale (magnetische Flüsse oder Feldgradienten) einer beliebigen Feldquelle detektieren lassen, sind allgemein bekannt. Dem in Figur 1 dargestellten Ausführungsbeispiel sei eine biomagnetische Feldquelle 2 wie z.B. das Gehirn eines Patienten 3 zugrundegelegt, obwohl ebensogut auch andere, beispielsweise nicht-biomagnetische Feldquellen zu detektieren sind. Entsprechende SQUID-Meßvorrichtungen können ein- oder mehrkanalig ausgeführt sein und enthalten zur Detektion der von der Feldquelle 2 ausgehenden magnetischen Signale mindestens ein als eine Antenne anzusehendes Magnetometer oder Gradiometer mit einer bzw. mehreren supraleitenden Spulen (Schleifen). Die detektierten Signale werden dann über supraleitende Verbindungsleiter einer der Kanalzahl entsprechenden Anzahl von SQUIDs zugeführt. Die SQUIDs können auch direkt in die Gradiometerspulen integriert sein, so daß dann besondere Verbindungseiter entfallen. Den SQUIDs, die gegebenenfalls wie die Gradiometerspulen zu einem Array zusammengefaßt sein können, ist eine Elektronik nachgeschaltet. In der Zeichnung sind diese bekannten Teile nicht näher ausgeführt. Die magnetfeldempfindlichen Teile der SQUID-Meßvorrichtung können insbesondere im Falle einer biomagnetischen Diagnostik in einer Abschirmkabine 16 untergebracht sein.

Mit Hilfe einer in dem schematischen Längsschnitt der Figur 1 veranschaulichten, allgemein mit KE1 bezeichneten Kühleinrichtung nach der Erfindung sind die nur angedeuteten SQUIDs 4 und Gradiometer 5 einer derartigen SQUID-Meßvorrichtung 9 auf ihrer kryogenen Betriebstemperatur zu halten. Hierzu sind die auf einer besonderen Trägerstruktur 7 angeordneten SQUIDs 4 und Gradiometer 5 innerhalb eines Kryostaten 6 von einem Isolationsvakuum 8 umschlossen. Sie werden nur indirekt über Wärmeleitung gekühlt. Das hierfür erforderliche, mit K₁ bezeichnete Kältemittel, beispielsweise flüssiges Helium (LHe) oder ein zweiphasiges Flüssig-Gas-Heliumgemisch wird durch eine flexible Kältemittel-Transferleitung 10 an die zu kühlende Trägerstruktur 7 geleitet. Dabei soll vorteilhaft das flüssige Kältemittel K₁ vollständig verdampfen. Das dann gasförmige Kältemittel K₂ kühlt auf seinem weiteren Weg weitere Teile der Trägerstruktur 7 und wenigstens einen Strahlungsschild 11 im Kryostaten 6 sowie einen Strahlungsschild 12 in der Transferleitung 10.

Das flüssige Kältemittel K₁ wird einer allgemein mit 13 bezeichneten, ein Kältemittel bereitstellenden Einheit entnommen, die einen einen Vorrat 14 an dem Kältemittel enthaltenden Kältemittelbehälter 15 aufweist. Dieser Behälter kann in bekannter Weise als ein Vorrats- und Transportgefäß ausgeführt sein und ist vorteilhaft außerhalb der durch ein Wandteilstück angedeuteten Abschirmkabine 16 angeordnet. Auf seinem Weg aus dem Vorrats- und Transportgefäß 15 strömt das Kältemittel K₁ durch eine LHe-Zuflußleitung 18 in der Transferleitung 10 in den Kryostaten 6, wo es in einen Kühlkanal 19 gelangt. Dieser Kühlkanal ist wärmeleitend mit einem die SQUIDs 4 aufnehmenden Teil der Trägerstruktur 7 verbunden. Bei diesem Teil der Trägerstruktur kann es sich insbesondere um ein metallisches Abschirmgehäuse 20 um die SQUIDs handeln, an das der Kühlkanal 19 z.B. angelötet ist. Die SQUIDs 4 sind dann an dieses Gehäuse 20 thermisch angekoppelt.

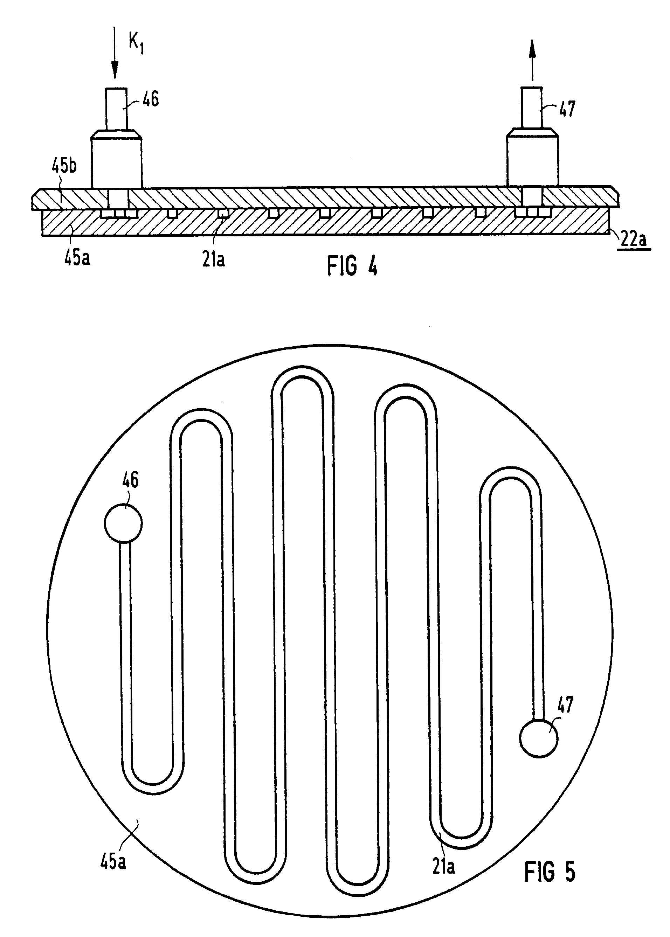

Nach der somit indirekten Kühlung der SQUIDs 4 gelangt das gegebenenfalls bereits teilweise verdampfte Kältemittel K₁ in Kühlkanäle 21a und 21b, die in den die Gradiometer 5 aufnehmenden Teil der Trägerstruktur 7 integriert sind. Dieser Teil der Trägerstruktur kann insbesondere als sogenannte Kühlplatten 22a bzw. 22b gestaltet sein und aus Kunststoff bestehen. Eine der Kühlplatten ist in den Figuren 4 und 5 näher veranschaulicht. Das nunmehr zumindest weitgehend gasförmige Kältemittel K₂ durchströmt anschließend weitere Strukturteile 24, an die thermisch der Strahlungsschild 11 des Kryostaten 6 angekoppelt ist, und gelangt danach in eine Abgasleitung 25 der Transferleitung 10. Diese Abgasleitung ist thermisch mit dem Strahlungsschild 12 der Transferleitung verbunden, die somit abgasgekühlt ist.

Die Transferleitung 10 enthält ferner einen Abschnitt, der als Durchführung 27 durch die Wand der Abschirmkabine 16 gestaltet ist. Da, abgesehen von dieser Durchführung 27, die Transferleitung zumindest in Teillängen flexibel ausgeführt sein kann, läßt sich vorteilhaft der Kryostat 6 in vielen Richtungen anordnen. Insbesondere ist so eine Anordnung sowohl über als auch unter dem Patienten 3 möglich. Zum Austauschen des Kühlmittel- Vorrats- und Transportgefäßes 15 kann ferner die Transferleitung 10 an einer in bekannter Weise auszuführenden Trennstelle 28 von dem Gefäß 15 abgetrennt werden.

Wie ferner aus Figur 1 zu entnehmen ist, kann gegebenenfalls das über die Transferleitung 10 aus der Abschirmkabine 16 herausgeführte gasförmige Kältemittel K₂ mittels eines Anwärmers 30 auf höhere Temperatur, beispielsweise Raumtemperatur, erwärmt werden. Der Abgasstrom wird dann über ein Stellventil 31, welches von einem Regler 32 angesteuert wird, abgeleitet und beispielsweise in einem nicht dargestellten Behälter aufgefangen.

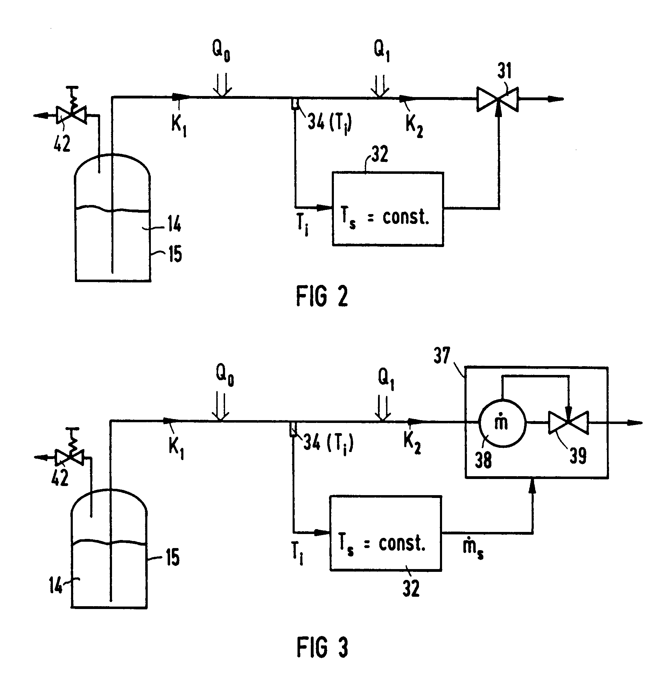

Seine Steuersignale erhält der Regler 32 über eine Steuerleitung 33 von einem Temperaturfühler 34, der in dem Kryostaten 6 an dem Teil 35 der Kältemittelleitung angebracht ist, der den Kühlkanälen 21a und 21b nachgeordnet ist. Mit einer Messung der Kältemitteltemperatur an dieser Stelle ist nämlich zu gewährleisten, daß die SQUIDs 4 und Gradiometer 5 jeweils in ihrem supraleitenden Betriebszustand gehalten werden, also zuverlässig kälter als die Sprungtemperatur ihres Supraleitermaterials sind. Mit Hilfe des Stellventils 31 am Ausgang der Kältemittelleitung außerhalb des Kryostaten 6 kann dann der gesamte Kältemittelstrom geregelt werden. Diese Regelung ist in Figur 2 skizziert. Demnach steuert der Regler 32 in Abhängigkeit von der an dem Temperaturfühler 34 gemessenen Ist-Temperatur Tᵢ das Stellventil 31 so, daß sich an der Meßstelle des Temperaturfühlers ein vorgegebener, zumindest weitgehend konstanter Soll-Wert Tₛ des dort gasförmigen Kältemittels K₂ einstellt. In der Figur sind schließlich noch die auf das Kältemittel K₁ in der Transferleitung 10 sowie in der Trägerstruktur 7 übertragenen Wärmemengen mit Qₒ und die in das gasförmige Kältemittel K₂ nach dem Temperaturfühler 34 über die Strahlungsschilde 11 und 12 sowie gegebenenfalls den Anwärmer 30 eingeleiteten Wärmemengen mit Q₁ als gepfeilte Linien angedeutet.

Zur Verbesserung der Regelgüte kann die Regelung gegebenenfalls gemäß Figur 3, für die eine Figur 2 entsprechende Darstellung gewählt ist, auch eine sogenannte Kaskadenregelung vorgesehen werden. Hierzu wird anstelle des in den Figuren 1 und 2 gezeigten Stellventils 31 ein Massenstromregler 37 eingesetzt. Zu diesem Zweck geeignete Massenstromregler sind allgemein bekannt und umfassen jeweils eine Vorrichtung 38 zur Messung des Massenstromdurchflusses ṁ sowie ein steuerbares Ventil 39. Mittels eines derartigen Massenstromreglers läßt sich dann der Massendurchfluß-Sollwert ṁₛ von dem Regler 32 in Abhängigkeit von dem an dem Temperaturfühler 34 gemessenen Ist-Wert Tᵢ der Temperatur steuern.

In den Figuren 1 bis 3 ist ferner angedeutet, daß Voraussetzung für die bei der Kühleinrichtung nach der Erfindung angenommene forcierte Kühlung ein Überdruck p ist, der insbesondere in dem Kühlmittelbehälter 15 innerhalb eines Druckbereiches von z.B. 100 bis 500 mbar herrschen soll. Hierzu ist in den Abgasstrom 41 dieses Behälters ein Druckhalteventil 42 eingebaut, das in dem Abgasraum 43 oberhalb des Vorrates 14 an flüssigem Kältemittel K₁ einen zumindest annähernd konstanten Wert des Überdruckes p aufrechterhält.

In den Figuren 4 und 5 ist eine der beiden in Figur 1 nur schematisch gezeigten Kühlplatten 22a, 22b der Trägerstruktur 7 als Quer- bzw. Längsschnitt näher veranschaulicht. Jede dieser gleichartig aufgebauten Kühlplatten kann beispielsweise aus einem mit Gasfasern verstärkten Kunststoff wie Epoxidharz bestehen. Auf ihnen sind die Spulen bzw. Schleifen der Gradiometer 5 aufgebracht, beispielsweise aufgeklebt. Wie aus Figur 4 hervorgeht, kann jede Platte, so auch die für die Darstellung ausgewählte Platte 22a, aus zwei aneinandergefügten plattenförmigen Elementen 45a und 45b zusammengesetzt sein. Dabei ist in mindestens eines dieser Elemente, z.B. in das Element 45a, der Kühlkanal 21a eingefräst. Dieser Kühlkanal führt von einer Einlaßstelle 46 für das noch zumindest teilweise flüssige Kältemittel K₁ zu einer Auslaßstelle 47. Wie aus Figur 5 ersichtlich ist, kann der Kühlkanal 21a (und damit auch der nicht dargestellte Kühlkanal 21b) vorteilhaft so verlaufen, daß eine zumindest weitgehend gleichmäßige Temperatur über die zu kühlende Fläche der Platte 22a gewährleistet ist. Gemäß dem dargestellten Ausführungsbeispiel ist deshalb für den Kühlkanal 21a eine Mäanderform gewählt. Auch sinusförmige oder spiralförmige Kühlkanäle sind ebensogut geeignet.

Aus dem schematischen Längsschnitt der Figur 6 geht eine weitere, allgemnein mit KE2 bezeichnete Kühleinrichtung nach der Erfindung mit einer SQUID-Meßvorrichtung 9 hervor. Diese Meßvorrichtung ist entsprechend den Figuren 1, 4 und 5 ausgeführt. Gemäß dieser Ausgestaltung der Kühleinrichtung KE2 wird das flüssige und gasförmige Kältemittel K₁ bzw. K₂ forciert in einem hermetisch geschlossenen Kältemittelkreislauf gefördert. Das hierfür erforderliche Kältemittelleitungssystem ist allgemein mit 51 bezeichnet. Es enthält einen kalten Leitungsteil 52, der von einer außerhalb der Abschirmkammer 16 befindlichen Kältemaschine 56 auf eine für eine Verflüssigung des Kältemittels K₁ hinreichend tiefe Temperatur gekühlt wird. Diese Kältemaschine 56 stellt bei dieser Ausführungform der Kühleinrichtung KE2 im wesentlichen die externe, allgemein mit 53 bezeichnete, ein Kältemittel bereitstellende Einheit dar. Bei der für das Ausführungsbeispiel gewählten Kältemaschine 56 handelt es sich um einen Gifford-McMahon(GM)-Refrigerator. Eine solche Kältemaschine weist vorteilhaft einen eigenen Verflüssigerkreislauf mit einer Kompressoreinheit 57 zum Verdichten des in dem Verflüssigerkreislauf zirkulierenden Mediums wie insbesondere Helium auf. Da dieser Verflüssigerkreislauf unabhängig von dem Kühlmittelkreislauf durch das Leitungssystem 51 ist und nur thermisch an diesen angekoppelt ist, können nämlich Vibrationen der Maschine mit dem Kühlmittelkreislauf gut eliminiert werden. Für den Temperaturbereich oberhalb von 10 K enthält die Kältemaschine 56 zwei Kühlstufen 58 und 59. Diesen beiden Stufen ist eine weitere Kühlstufe 60 nachgeordnet, die nach dem Joule-Thomson(JT)-Effekt eine Abkühlung auf etwa 4 K bewirkt und deshalb auch als 4 K-Kühlstufe bezeichnet werden kann. Eine entsprechende Kältemaschine ist z.B. der genannten Textstelle in "Cryocoolers 5" oder der DE-B-34 27 601 zu entnehmen. Ihre Kühlstufen 58 bis 60 befinden sich in einem Kühlgehäuse 62, in dessen Innenraum ein die beiden kälteren Stufen 59 und 60 aufnehmender Teilraum von einem an die erste Kühlstufe 58 thermisch angekoppelten Wärmeschild 63 begrenzt wird.

Das an der 4 K-Kühlstufe 60 der Kältemaschine 56 verflüssigte Kältemittel K₁ wird aus dem Gehäuse 62 herausgeführt und über eine zumindest teilweise flexible Kältemitteltransferleitung 65 in den Kryostaten 6 der SQUID-Meßvorrichtung 9 eingeleitet. Die Kältemitteltransferleitung 65 entspricht dabei weitgehend der Transferleitung 10 nach Figur 1.

Das über die Transferleitung 65 aus dem Kryostaten 6 ausgeleitete, in dieser Leitung weiter aufgewärmte gasförmige Kältemittel K₂ wird nicht direkt einer auf Raumtemperatur befindlichen Umwälzpumpe 70 zugeführt, die die forcierte Strömung in dem Kältemittelleitungssystem 51 gewährleistet. Vielmehr wird das Kältemittel K₂ noch vorteilhaft zu einer Vorkühlung des von der Umwälzpumpe 70 der ersten Stufe 58 der Kältemaschine 56 zugeführten, noch etwa auf Raumtemperatur befindlichen Kältemittel Kₒ herangezogen. Ein hierfür vorgesehener Wärmetauscher 71 befindet sich in dem Kühlgehäuse 62 außerhalb des von dessen Wärmeschild 63 begrenzten Teilraumes. Um eine hinreichende Menge des Kältemittels Kₒ in dem Kühlkreislauf des Leitungsystems 51 aufrechtzuerhalten, ist außerdem an das Leitungssystem noch im Raumtemperaturbereich und in Kältemittelströmungsrichtung gesehen nach der Umwälzpumpe 70 ein Speicher 72 für einen hinreichenden Vorrat an gasförmigem Kältemittel angeschlossen.

Wie ferner der Figur 6 zu entnehmen ist, muß bei Vorhandensein einer Abschirmkabine 16 die Transferleitung 65 einen Abschnitt enthalten, der als Durchführung 73 durch die Wand der Kabine gestaltet ist. Im Bereich dieser Durchführung sind die einzelnen Kältemittelleitungen der Transferleitung 65 elektrisch isoliert. Da, abgesehen von der Durchführung 73, die Transferleitung zumindest in Teillängen flexibel ausgeführt sein und beispielsweise einen mit dem Kühlgehäuse 62 verbundenen starren Leitungsteil 65a sowie einen mit dem Kryostaten 6 verbundenen flexiblen Leitungsteil 65b aufweisen kann, läßt sich vorteilhaft auch bei dieser Ausführungform der Kühleinrichtung KE2 der Kryostat in viele Richtungen ausrichten. Zu einem Austauschen der Kältemaschine 56, beispielsweise in einem Störungs- oder Wartungsfall, oder für einen Notbetrieb zum Anschluß eines LHe-Vorratsbehälters kann ferner die Transferleitung 65 an der in bekannter Weise auszuführenden Kupplung 28 aufgetrennt werden.

Gemäß dem anhand von Figur 6 erläuterten Ausführungsbeispiel kommt für eine Kühleinrichtung nach der Erfindung als Kältemaschine vor allem ein dreifstufiger Refrigerator aus zweistufiger GM-Maschine und nachgeordneter JT-Stufe in Betracht. Prinzipiell kann jedoch die Kühleinrichtung auch mit jedem anderen Typ einer Kältemaschine (Refrigerator) aufgebaut werden, die über einen eigenen, von dem Kältemittelkreislauf für die supraleitenden Teile der SQUID-Meßvorrichtung getrennten Verflüssigerkreislauf verfügt und an deren kältester (4 K-) Stufe der Kältemittelkreislauf thermisch angekoppelt ist. So lassen sich z.B. auch Kältemaschinen verwenden, deren kälteste Stufe als GM-Stufe ausgelegt ist. Darüber hinaus ist ebensogut eine Kältemaschine einsetzbar, die nach dem Linde-Claude-Prinzip arbeitet (vgl. "E und M", 90. Jg., 1973, Seiten 218 bis 224). Eine entsprechende Maschine ist in Figur 7 angedeutet und mit 80 bezeichnet. Dabei zeigt diese Figur nur die Maschine 80 und einen Teil einer Kältemitteltransferleitung 65. Die nicht-dargestellten Teile einer SQUID-Meßvorrichtung entsprechen denen gemäß Figur 1 oder Figur 6. Die Kältemaschine 80 enthält einen Kompressor 81, zwei hintereinander angeordnete Expansionsturbinen 82a und 72b, fünf Gegenstromwärmetauscher 83a bis 83e sowie einen Kältemittelhochdruckzweig 84 und einen Kältemittelniederdruckzweig 85 durch diese Wärmetauscher. Ein Anteil des von dem Kompressor 81 verdichteten Kältemittels Kₒ wird aus dem Hochdruckzweig 84 entnommen, über die Expansionsturbinen 82a und 82b entspannt und dann in den Niederdruckzweig 85 eingespeist. Der verbleibende Teilstrom des Hochdruckzweiges wird an dessen Ende mittels eines JT-Ventils 86 teilweise verflüssigt. Der so an dieser kältesten Stufe der Maschine gewonnene Flüssigkeitsstrom K wird über einen kalten Leitungsteil 87 einer Verzweigung 88 zugeführt, wo er in zwei Teilströme K′ und K₁ aufgeteilt wird. Der Teilstrom K₁ dient entsprechend Figur 6 zur Kühlung der supraleitenden Teile einer SQUID-Meßvorrichtung 9. Seine Kältemittelmenge wird über ein Ventil 89 eingestellt. Der andere Teilstrom K′ bildet nach Durchlaufen der Wärmetauscher 83e bis 83a des Niederdruckzweiges 85, wobei er verdampft, zusammen mit dem von der SQUID-Meßvorrichtung über die Transferleitung 65 zurückkommenden gasförmigen Kältemittel K₂ einen gemeinsamen Kältemittelgasstrom G. Dieser Gasstrom wird dann dem Kompressor 81 zugeleitet. Eine derartige Kältemaschine 80 stellt also einen in das Kältemittelleitungssystem 51 einer erfindungsgemäßen Kühleinrichtung KE2 integrierten Teil dar. Vibrationsprobleme sind dabei nicht zu befürchten, weil die in einem Verflüssigerkreis nach dem Linde-Claude-Prinzip mit Turbinen hervorgerufenen Vibrationen gering sind.

Eine erfindungsgemäße Kühleinrichtung mit den anhand der Figuren 6 und 7 erläuterten Maßnahmen läßt somit einen Dauerbetrieb einer SQUID-Meßvorrichtung zu, wobei die Temperatur aller supraleitenden Teile unter der Sprungtemperatur des verwendeten surpaleitenden Materials, also beispielsweise unter 6 K zu halten ist. Eine Übertragung von Vibrationen auf die SQUID-Meßvorrichtung kann dabei vermieden werden. Deren supraleitende Teile können als kompaktes Meßsystem in einem entsprechend kleinen Kryostaten ausgeführt sein, wobei eine beliebige Orientierung dieses Kryostaten möglich ist. Gegebenenfalls läßt sich auch z.B. an der Durchführung durch die Wand einer Abschirmkabine eine Potentialtrennung zwischen elektrisch leitenden Teilen außerhalb und innerhalb der Abschirmkabine vornehmen.

## Patentansprüche

1. Einrichtung (KE1, KE2) zur Kühlung einer SQUID-Meßvorrichtung (9), mit der biomagnetische oder sonstige schwache Magnetfelder zu messen sind, mit folgenden Merkmalen:
a) Es ist ein Kryostat (6) vorgesehen, in dessen Innenraum mindestens ein supraleitendes Gradiometer (5) sowie mindestens ein zugeordnetes SQUID (4) in einem Vakuum (8) angeordnet sind,
b) das mindestens eine SQUID (4) und das mindestens eine Gradiometer (5) sind auf einer Trägerstruktur (7; 20, 22a, 22b) angeordnet,
c) die Trägerstruktur (7; 20, 22a, 22b) ist mit Kühlkanälen (19, 21a, 21b) versehen, durch welche ein Kältemittel (K₁) forciert hindurchzuleiten ist, und koppelt das mindestens eine SQUID (4) und das mindestens eine Gradiometer (5) thermisch an das Kältemittel (K₁) an,
d) die Kühlkanäle (19, 21a, 21b) sind über eine Kältemitteltransferleitung (10; 65) mit einer außerhalb des Kryostaten (6) befindlichen, das Kältemittel (K1) bereitstellenden Einheit (13; 53) verbunden, wobei das Kältemittel (K1) in den Kryostaten (6) mit einer die kryogene Betriebstemperatur des mindestens einen SQUIDs (4) und des mindestens einen Gradiometers (5) gewährleistenden Temperatur eintritt.

2. Kühleinrichtung nach Anspruch 1, **dadurch gekennzeichnet**, daß die Trägerstruktur (7) zur Aufnahme des Gradiometers (5) Kühlplatten (22a, 22b) enthält, in welche die entsprechenden Kühlkanäle (21a, 21b) integriert sind.

3. Kühleinrichtung nach Anspruch 2, **dadurch gekennzeichnet**, daß jede Kühlplatte (22a, 22b) aus zwei plattenförmigen Elementen (45a, 45b) zusammengesetzt ist, wobei in eines (45a) dieser Elemente einer der Kühlkanäle (21a) eingearbeitet ist.

4. Kühleinrichtung nach Anspruch 3, **dadurch gekennzeichnet**, daß der Kühlkanal (21a) in dem plattenförmigen Element (45a) der Kühlplatte (22a) mäanderförmig verläuft.

5. Kühleinrichtung nach einem der Ansprüche 2 bis 4, **dadurch gekennzeichnet**, daß die Kühlplatten (22a, 22b) aus einem mit Glasfasern verstärkten Kunststoff bestehen.

6. Kühleinrichtung nach einem der Ansprüche 1 bis 5, **dadurch gekennzeichnet**, daß die Trägerstruktur (7) zur Aufnahme des SQUIDs (4) ein metallisches Abschirmgehäuse (20) enthält, das wärmeleitend mit einem Kühlkanal (19) und dem SQUID (4) verbunden ist.

7. Kühleinrichtung nach einem der Ansprüche 1 bis 6, **dadurch gekennzeichnet**, daß in dem Kryostaten (6) und in der Kältemitteltransferleitung (10; 65) jeweils ein thermischer Strahlungsschild (11 bzw. 12) angeordnet ist, der thermisch an gasförmiges Kältemittel (K₂) angekoppelt ist.

8. Kühleinrichtung nach einem der Ansprüche 1 bis 7, **dadurch gekennzeichnet**, daß der Kryostat (6) innerhalb und die das Kältemittel (K1) bereitstellende Einheit (13; 53) außerhalb einer Abschirmkabine (16) angeordnet sind.

9. Kühleinrichtung nach einem der Ansprüche 1 bis 8, **dadurch gekennzeichnet**, daß die Kühlmitteltransferleitung (10; 65) zumindest teilweise flexibel gestaltet ist.

10. Kühleinrichtung nach einem der Ansprüche 1 bis 9, **dadurch gekennzeichnet**, daß die das Kältemittel bereitstellende Einheit (13) einen Kältemittelbehälter (15) aufweist.

11. Kühleinrichtung nach Anspruch 10, **dadurch gekennzeichnet**, daß zu der forcierten Förderung des Kältemittels (K₁, K₂) durch die Kühlkanäle (19, 21a, 21b) der Trägerstruktur (7) ein in dem Abgasraum (43) des Kältemittelbehälters (15) ausgebildeter Überdruck (p) herangezogen ist.

12. Kühleinrichtung nach Anspruch 10 oder 11, **dadurch gekennzeichnet**, daß zur Regelung des Kühlmittelstroms durch die Kühlkanäle (19, 21a, 21b) der Trägerstruktur (7) außerhalb des Kryostaten (6) ein Stellventil (31, 39) am Ausgang einer Abgasleitung vorgesehen ist, das von einem Regler (32) in Abhängigkeit von der an einem Temperaturfühler (34) gemessenen Temperatur (Tᵢ) gesteuert ist, wobei der Temperaturfühler (34) an einem Kältemittelleitungsteil (35) angebracht ist, der in Strömungsrichtung des Kältemittels gesehen hinter den Kühlkanälen (19, 21a, 21b) der Trägerstruktur (7) liegt und gasförmiges Kältemittel (K₂) führt.

13. Kühleinrichtung nach Anspruch 12, **dadurch gekennzeichnet**, daß das Stellventil (39) Teil eines Massenstromreglers (37) ist.

14. Kühleinrichtung nach einem der Ansprüche 1 bis 9, **dadurch gekennzeichnet**,
- daß die das Kältemittel (K1) bereitstellende Einheit (53) eine Kältemaschine (56, 80) ist,
- daß zu der forcierten Führung des Kältemittels (K, Kₒ, K₁, K₂, G) in einem geschlossenen Kältemittelkreislauf ein Kältemittelleltungssystem (51) vorgesehen ist, das einen kalten Leitungsteil (52, 87) aufweist, der mit der kältesten Stufe (60, 86) der Kältemaschine (56, 80) verbunden ist,
und
- daß die Kühlkanäle (19, 21a, 21b) der Trägerstruktur (7) über die Kältemitteltransferleitung (65) an den kalten Leitungsteil (52, 87) angeschlossen sind.

15. Kühleinrichtung nach Anspruch 14, **dadurch gekennzeichnet**, daß zu der forcierten Förderung des Kältemittels (K, K₀, K₁, K₂, G) durch das Kältemittelleitungssystem (51) eine Pumpe (70, 81) vorgesehen ist.

16. Kühleinrichtung nach Anspruch 14 oder 15, **dadurch gekennzeichnet**, daß das Kältemittel (K₁) in dem kalten Leitungsteil (52) an die kälteste Stufe (60) der Kältemaschine (56) thermisch angekoppelt ist.

17. Kühleinrichtung nach einem der Ansprüche 14 bis 16, **dadurch gekennzeichnet**, daß die Kältemaschine (56) mehrere gemäß dem Gifford-McMahon-Prinzip arbeitende Kühlstufen (58, 59) aufweist.

18. Kühleinrichtung nach Anspruch 17, **dadurch gekennzeichnet**, daß die kälteste Stufe (60) der Kältemaschine (56) eine Joule-Thomson-Stufe ist.

19. Kühleinrichtung nach einem der Ansprüche 14 bis 18, **dadurch gekennzeichnet**, daß zumindest im Bereich des kalten Leitungsteils (87) in den Kühlmittelkreislauf zur Kühlung des mindestens einen SQUIDs (4) und des mindestens einen Gradiometers (5) ein Verflüssigerkreislauf der Kältemaschine (80) integriert ist.

20. Kühleinrichtung nach einem der Ansprüche 14 bis 16 und 19, **dadurch gekennzeichnet**, daß die Kältemaschine (80) ein gemäß dem Linde-Claude-Prozeß arbeitender Refrigerator ist.

## Claims

1. Device (KE1, KE2) for cooling a SQUID measuring instrument (9) with which biomagnetic or other weak magnetic fields are to be measured, comprising the following features:
a) a cryostat (6) is provided, in whose interior space at least one superconducting gradiometer (5) and at least one associated SQUID (4) are disposed in a vacuum (8),
b) the at least one SQUID (4) and the at least one gradiometer (5) are disposed on a carrier structure (7; 20, 22a, 22b),
c) the carrier structure (7; 20, 22a, 22b) is provided with cooling channels (19, 21a, 21b) through which a cryogen (K₁) is forcibly to be conducted, and couples the at least one SQUID (4) and the at least one gradiometer (5) thermally to the cryogen (K₁),
d) the cooling channels (19, 21a, 21b) are connected via a cryogen transfer line (10; 65) to a unit (13; 53) situated outside the cryostat (6) and supplying the cryogen (K₁), wherein the cryogen (K₁) enters the cryostat (6) at a temperature ensuring the cryogenic operating temperature of the at least one SQUID (4) and the at least one gradiometer (5).

2. Cooling device according to claim 1, characterized in that the carrier structure (7) for accommodating the gradiometer (5) comprises cooling plates (22a, 22b) in which the corresponding cooling channels (21a, 21b) are integrated.

3. Cooling device according to claim 2, characterized in that each cooling plate (22a, 22b) is composed of two plate-shaped elements (45a, 45b), one of the cooling channels (21a) being recessed into one (45a) of these elements.

4. Cooling device according to claim 3, characterized in that the cooling channel (21a) in the plate-shaped element (45a) of the cooling plate (22a) extends in a meander shape.

5. Cooling device according to one of claims 2 to 4, characterized in that the cooling plates (22a, 22b) are made of a plastic reinforced with glass fibres.

6. Cooling device according to one of claims 1 to 5, characterized in that the carrier structure (7) for accommodating the SQUID (4) comprises a metallic screening box (20) connected thermally conductively to a cooling channel (19) and to the SQUID (4).

7. Cooling device according to one of claims 1 to 6, characterized in that respective thermal radiation shields (11 and 12) are arranged in the cryostat (6) and in the cryogen transfer line (10; 65), the said radiation shields being thermally coupled to gaseous cryogen (K₂).

8. Cooling device according to one of claims 1 to 7, characterized in that the cryostat (6) is disposed inside a screening cubicle (16) and the unit (13; 53) supplying the cryogen (K₁) is disposed outside it.

9. Cooling device according to one of claims 1 to 8, characterized in that the coolant transfer line (10; 65) is designed so as to be at least partially flexible.

10. Cooling device according to one of claims 1 to 9, characterized in that the unit (13) supplying the cryogen has a cryogen tank (15).

11. Cooling device according to claim 10, characterized in that an excess pressure (p) formed in the exhaust gas space (43) of the cryogen tank (15) is used for forcibly conveying the cryogen (K₁, K₂) through the cooling channels (19, 21a, 21b) of the carrier structure (7).

12. Cooling device according to claim 10 or 11, characterized in that to control the coolant flow through the cooling channels (19, 21a, 21b) of the carrier structure (7), a regulating valve (31, 39) is provided outside the cryostat (6), at the outlet of an exhaust gas line, the said regulating valve being controlled by a controller (32) as a function of the temperature (Tᵢ) measured by a temperature sensor (34), the temperature sensor (34) being mounted on a cryogen line section (35) which is situated downstream of the cooling channels (19, 21a, 21b) of the carrier structure (7), when viewed in the direction of flow of the cryogen, and which conveys gaseous cryogen (K₂).

13. Cooling device according to claim 12, characterized in that the regulating valve (39) is part of a mass-flow controller (37).

14. Cooling device according to one of claims 1 to 9, characterized
- in that the unit (53) supplying the cryogen (K₁) is a refrigeration machine (56, 80),
- in that for forcibly conveying the cryogen (K, K₀, K₁, K₂, G) in a closed cryogen circulation there is provided a cryogen piping system (51) which has a cold line section (52, 87) connected to the coldest stage (60, 86) of the refrigeration machine (56, 80),
and
- in that the cooling channels (19, 21a, 21b) of the carrier structure (7) are connected via the cryogen transfer line (65) to the cold line section (52, 87).

15. Cooling device according to claim 14, characterized in that a pump (70, 81) is provided for forcibly conveying the cryogen (K, K₀, K₁, K₂, G) through the cryogen piping system (51).

16. Cooling device according to claim 14 or 15, characterized in that the cryogen (K₁) in the cold line section (52) is thermally coupled to the coldest stage (60) of the refrigeration machine (56).

17. Cooling device according to one of claims 14 to 16, characterized in that the refrigeration machine (56) has several cooling stages (58, 59) operating according to the Gifford-McMahon principle.

18. Cooling device according to claim 17, characterized in that the coldest stage (60) of the refrigeration machine (56) is a Joule-Thomson stage.

19. Cooling device according to one of claims 14 to 18, characterized in that a condenser circulation of the refrigeration machine (80) is integrated at least in the vicinity of the cold line section (87) in the coolant circulation to cool the at least one SQUID (4) and the at least one gradiometer (5).

20. Cooling device according to one of claims 14 to 16 and 19, characterized in that the refrigeration machine (80) is a refrigerator operating in accordance with the Linde-Claude process.

## Revendications

1. Dispositif (KE1, KE2) de refroidissement pour un dispositif de mesure à SQUID (9), avec lequel on peut mesurer des champs biomagnétiques ou d'autres champs magnétiques à faible intensité, ayant les caractéristiques suivantes:
a) il est prévu un cryostat (6), à l'intérieur duquel sont agencés dans un vide (8) au moins un gradiomètre supraconductif (5) ainsi qu'au moins un SQUID (4) correspondant,
b) le au moins un SQUID (4) et le au moins un gradiomètre (5) sont agencés sur une structure de support (7, 20, 22a, 22b),
c) la structure de support (7, 20, 22a, 22b) est pourvue de canaux de refroidissement (19, 21a, 21b), à travers lesquels on doit faire passer de force un produit réfrigérant (K₁), et accouple le au moins un SQUID (4) et le au moins un gradiomètre (5) thermiquement au produit réfrigérant (K₁),
d) les canaux de refroidissement (19, 21a, 21b) sont connectés au moyen d'une canalisation de transfert du produit réfrigérant (10, 65) à une unité (13, 53) d'approvisionnement en produit réfrigérant (K₁), qui se trouve à l'extérieur du cryostat (6), le produit réfrigérant (K₁) entrant dans le cryostat (6) à une température qui garantit la température de service cryogène du au moins un SQUID (4) et du au moins un gradiomètre (5).

2. Dispositif de refroidissement selon la revendication 1, caractérisé en ce que la structure de support (7) destinée à la réception du gradiomètre (5) comprend des plaques de refroidissement (22a, 22b), dans lequelles sont intégrés les canaux de refroidissement (21a, 21b) correspondants.

3. Dispositif de refroidissement selon la revendication 2, caractérisé en ce que chaque plaque de refroidissement (22a, 22b) est composée de deux éléments en forme de plaque (45a, 45b), dans lequel un des canaux de refroidissement (21 a) est incorporé dans l'un (45a) de ces éléments.

4. Dispositif de refroidissement selon la revendication 3, caractérisé en ce que le tracé du canal de refroidissement (21a) dans l'élément en forme de plaque (45a) de la plaque de refroidissement (22a) a une forme de méandre.

5. Dispositif de refroidissement selon l'une des revendications 2 à 4, caractérisé en ce que les plaques de refroidissement (22a, 22b) se composent d'une matière synthétique renforcée par des fibres de verre.

6. Dispositif de refroidissement selon l'une des revendications 1 à 5, caractérisé en ce que la structure de support (7) destinée à la réception du SQUID (4) comprend une boîte de blindage (20) métallique, qui est connectée de façon thermo-conductive à un canal de refroidissement (19) et au SQUID (4)

7. Dispositif de refroidissement selon l'une des revendications 1 à 6, caractérisé en ce qu'un bouclier thermique antiradiation (11 resp. 12) est agencé respectivement dans le cryostat (6) et dans la canalisation de transfert du produit réfrigérant (10, 65), ce bouclier étant accouplé de façon thermo-conductive à un produit réfrigérant gazeux (K₂).

8. Dispositif de refroidissement selon l'une des revendications 1 à 7, caractérisé en ce que le cryostat (6) est aménagé à l'intérieur d'une cabine de blindage (16) et en ce que l'unité (13, 53) d'approvisionnement en produit réfrigérant (K₁) est aménagée à l'extérieur de celle-ci.

9. Dispositif de refroidissement selon l'une des revendications 1 à 8, caractérisé en ce que la canalisation de transfert du produit réfrigérant (10, 65) est du moins partiellement flexible.

10. Dispositif de refroidissement selon l'une des revendications 1 à 9, caractérisé en ce que l'unité (13) d'approvisionnement en produit réfrigérant présente un réservoir de produit réfrigérant (15).

11. Dispositif de refroidissement selon la revendication 10, caractérisé en ce qu' une surpression établie dans le compartiment à gaz (43) du réservoir de produit réfrigérant (15) est utilisée pour le transport forcé du produit réfrigérant (K₁, K₂) à travers les canaux de refroidissement (19, 21a, 21b) de la structure de support (7).

12. Dispositif de refroidissement selon la revendication 10 ou 11, caractérisé en ce que pour le réglage du courant de produit réfrigérant à travers les canaux de refroidissement (19, 21a, 21b) de la structure de support (7), une soupape de réglage (31, 39) est prévue à la sortie d'une conduite de gaz d'échappement à l'extérieur du cryostat (6), qui est commandée par un régulateur (32) en fonction de la température (Tᵢ) mesurée à l'aide d'une sonde de température (34), la sonde de température (34) étant agencée à une portion de la conduite de produit réfrigérant, qui, vue dans la direction du courant de produit réfrigérant, se trouve derrière les canaux de refroidissement (19, 21a, 21b) de la structure de support (7) et qui contient du produit réfrigérant gazeux (K₂).

13. Dispositif de refroidissement selon la revendication 12, caractérisé en ce que la soupape de réglage (39) fait partie d'un régulateur de débit massique (37).

14. Dispositif de refroidissement selon l'une des revendications 1 à 9, caractérisé
- en ce que l'unité (53) d'approvisionnement en produit réfrigérant (K₁) est une machine frigorifique (56, 80),
- en ce que pour le transport forcé du produit réfrigérant (K, K₀, K₁, K₂, G) dans un cicuit de produit réfrigérant fermé, un système (51) de conduites de produit réfrigérant est prévu, qui présente une partie froide de conduite (52, 87), qui elle est raccordée à l'étage le plus froid (60, 80) de la machine frigorifique (56, 80), et
- en ce que les canaux de refroidissement (19, 21a, 21 b) de la structure de support (7) sont raccordés par la canalisation de transfert du produit réfrigérant (65) à la partie froide de conduite (52, 87).

15. Dispositif de refroidissement selon la revendication 14, caractérisé en ce qu'une pompe (70, 81) est prévue pour le transport forcé du produit réfrigérant (K, K₀, K₁, K₂, G) à travers le système (51) de conduites de produit réfrigérant.

16. Dispositif de refroidissement selon la revendication 14 ou 15, caractérisé en ce que le produit réfrigérant (K₁) dans la partie froide de conduite (52) est accouplé thermiquement à l'étage le plus froid (60) de la machine frigorifique (56).

17. Dispositif de refroidissement selon l'une des revendications 14 à 16, caractérisé en ce que la machine frigorifique (56) présente plusieurs étages de refroidissement (58, 59) travaillant selon le principe de Gifford-McMahon.

18. Dispositif de refroidissement selon la revendication 17, caractérisé en ce que l'étage le plus froid (60) de la machine frigorifique (56) est un étage Joule-Thomson.

19. Dispositif de refroidissement selon l'une des revendications 14 à 18, caractérisé en ce qu'au moins dans le domaine de la partie froide de conduite (87), un circuit condenseur de la machine frigorifique (80) est intégré dans le circuit du produit réfrigérant pour le refroidissement du au moins un SQUID (4) et du au moins un gradiomètre (5).

20. Dispositif de refroidissement selon l'une des revendications 14 à 16 et 19, caractérisé en ce que la machine frigorifique (80) est un réfrigérateur travaillant selon le principe de Linde-Claude.
